# EUROPÄISCHE PATENTSCHRIFT

(11) **EP 0 873 673 B1**
(45) Veröffentlichungstag und Bekanntmachung des Hinweises auf die Patenterteilung: **08.03.2000**
(21) Anmeldenummer: 96946150.8
(22) Anmeldetag: 20.12.1996
(51) Int. Cl.: H05K 7/20

(54) **STEUERGERÄT BESTEHEND AUS MINDESTENS ZWEI GEHÄUSETEILEN**
CONTROL DEVICE CONSISTING OF AT LEAST TWO HOUSING SECTIONS
APPAREIL DE COMMANDE COMPOSE D'AU MOINS DEUX PARTIES DE BOITIER

(30) Priorität: 10.01.1996 DE 19600619
(43) Veröffentlichungstag der Anmeldung: 28.10.1998
(73) Patentinhaber: ROBERT BOSCH GMBH, 70442 Stuttgart (DE)
(72) Erfinder: BENTZ, Willy, D-74343 Sachsenheim (DE); JARES, Peter, 71120 Grafenau (DE); KARR, Dieter, D-75233 Tiefenbronn (DE); HERMANUTZ, Paul, D-72810 Gomaringen (DE); ERNST, Waldemar, D-71665 Vaihingen (DE)
(86) Internationale Anmeldenummer: DE9602500
(87) Internationale Veröffentlichungsnummer: WO9725846

(56) Entgegenhaltungen:
- EP-A- 0 625 871
- EP-A- 0 668 715
- DE-A- 4 222 838
- DE-U- 9 200 624

## Beschreibung

### Stand der Technik

Die Erfindung geht aus von einem Steuergerät bestehend aus mindestens zwei Gehäuseteilen nach der Gattung der unabhängigen Ansprüche. Bei einem aus dem DE-Gbm 92 006 24.8 bekannten Steuergerät wird eine Leiterplatte zwischen zwei Gehäuseteilen, d.h. einem Gehäusedeckel und einem Gehäuseboden mit Hilfe von Verschraubungen fest eingesetzt. Der Gehäusedeckel und der Gehäuseboden sind aus gut wärmeleitendem Material hergestellt. Um die Verlustwärme der auf der Leiterplatte angeordneten Leistungsbauelemente über die Gehäuseteile abführen zu können, ist die Leiterplatte mit einer wärmeleitenden Schicht, z.B. einer Kupferkaschierung oder einer wärmeleitenden Schicht versehen. Insbesondere neuartige Leistungsbauelemente haben aber eine so hohe Verlustleistung, die mit Hilfe der herkömmlichen wärmeleitenden Schicht und des bisherigen konstruktiven Aufbaus nur sehr schwer nach außen abgeleitet werden können. Bei anderen Steuergerätekonzepten wird zur Wärmeableitung die Unterseite des die Leistungsbauelemente tragenden Substrats vollständig mit einer wärmeableitenden Schicht versehen. Dadurch kann diese Seite der Leiterplatte nicht mehr mit Leistungsbauelementen bestückt werden, wodurch sich ein Flächenmehrbedarf und somit eine hohe Kostenentwicklung ergibt.

Aus EP-A-0842594, die unter Artikel 54(3) EPÜ fällt, ist ferner ein Steuergerät bekannt, das aus mindestens zwei Gehäuseteilen besteht, und bei dem die Ränder des Gehäusedeckels und des Gehäusebodens mehrere fluchtende Bohrungen haben, die auch die Leiterplatte durchdringen, und in die Schrauben eingesetzt sind, die den Gehäusedeckel, die Leiterplatte und den Gehäuseboden fest miteinander verbinden. Dieses Gerät weist jedoch kein mechanisches Hilfsmittel zwischen mindestens einem zu kühlenden Leistungsbauelement und dem ersten Gehäuseteil oder zwischen der Leiterplatte und mindestens einem Gehäuseteil oder zwischen der Leiterplatte und dem zweiten Gehäuseteil oder dem erstenGehäuseteil auf.

### Vorteile der Erfindung

Das erfindungsgemäße Steuergerät mit den kennzeichnenden Merkmalen des Hauptanspruchs hat demgegenüber den Vorteil, daß ein relativ geringer thermischer Übergangswiderstand zwischen der Leiterplatte und der als Kühlelement dienenden Auflagefläche des Gehäusebodens besteht. Durch die mechanischen Hilfsmittel kann in einfacher und preisgünstiger Weise eine Anpreßkraft der Leiterplatte auf dem Kühlelement erzeugt werden. Gegebenenfalls kann auch zwischen der Auflagefläche des Gehäusebodens und der Unterseite der Leiterplatte ein wärmeleitender Kleber angebracht werden, wodurch die thermische Leitfähigkeit nochmals optimiert wird. Die Anpreßkraft kann durch einfache konstruktive Maßnahmen erzeugt werden, wodurch das Gerät bei sehr günstigen Kosten hergestellt werden kann. Eine Einschränkung auf bestimmte Leiterplatten ist nicht notwendig. Ferner ist auch eine Bestückung bis auf den Auflagebereich der Leiterplatte auf dem Gehäuseteil in einfacher Weise auf beiden Seiten mit Bauelementen möglich.

Weitere Vorteile und vorteilhafte Weiterbildungen ergeben sich aus der Beschreibung und der Zeichnung.

### Zeichnung

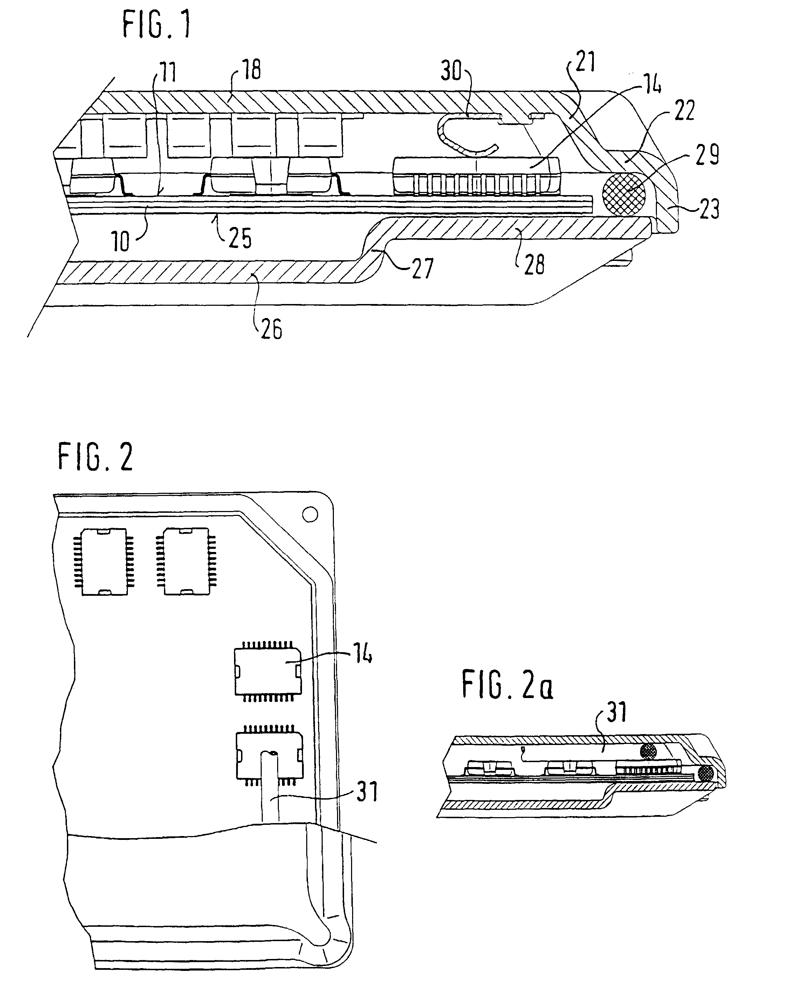

Ausführungsbeispiele der Erfindung sind in der Zeichnung dargestellt und in der nachfolgenden Beschreibung näher erläutert. Die Figuren 1 bis 5 zeigen je einen Schnitt durch eine schematische Darstellung eines Teils eines Steuergeräts.

### Beschreibung der Ausführungsbeispiele

Das elektrische Schalt- oder Steuergerät hat eine Leiterplatte 10 auf deren Oberseite 11 eine elektronische Schaltung aufgebaut ist, von der nur einige elektronische Bauelemente 14, die Verlustwärme bei Betrieb abgeben, dargestellt sind. In der Zeichnung sind diese Bauelemente 14 als SMD-Bauelemente (Surface-Mounted-Device) ausgeführt. In nicht dargestellter Weise ist die Leiterplatte 10 in herkömmlicher Weise mit einer Steckerleiste verbunden.

Die Oberseite 11 der Leiterplatte 10 wird von einem wannenförmigen Gehäusedeckel 18 abgedeckt. Bis auf den Bereich der Steckerleiste hat der Gehäusedeckel 18 an seinen Gehäusewänden 21 einen durchgehenden, kragenförmigen Rand 22. Die Leiterplatte 10 kann dabei, wie in der Figur 1 dargestellt, bis etwa zur Seitenwand 21 reichen. Die Bauelemente 14 können dadurch bis an den Rand der Leiterplatte 10 angeordnet sein. Hingegen ist es auch möglich, den Rand der Leiterplatte 10 frei von Schaltungsbauteilen und Leiterbahnen zu halten, so daß dieser Rand der Leiterplatte 10 bis unter den Rand 22 des Gehäusedeckels 18 ragt.

Der durchgehende Rand 22 hat eine abgewinkelte, in etwa senkrecht zum Rand 22 verlaufende Kante 23, die bis über die Stirnseite der Leiterplatte 10 ragt.

Die Unterseite 25 der Leiterplatte 10 wird von einem ebenfalls wannenförmigen Gehäuseboden 26 umfaßt, dessen Seitenwände 27 einen durchgehenden, kragenförmigen Rand 28 haben, der mittel- oder unmittelbar auf dem äußeren Bereich der Unterseite 25 der Leiterplatte 10 anliegt. Bevorzugt in diesem Randbereich 28 liegen auch die Leistungsbauelemente 14, deren Wärme abgeleitet werden muß, auf der Leiterplatte 10 auf. Der Rand 28 schließt in der Figur 1 mit der Kante 23 des Gehäusedeckels 18 etwa bündig ab, so daß die Leiterplatte 10 mit Hilfe eines Dichtrings 29 zwischen dem Gehäusedeckel 18 und dem Gehäuseboden 26, d.h. zwischen dem Rand 22 des Gehäusedeckels 18 und dem Rand 28 des Gehäusebodens 26 eingeschlossen ist. Befestigt werden der Gehäusedeckel 18 und der Gehäuseboden 26 zum Beispiel mit mehreren an den Ecken des Gehäuses angeordneten Schrauben. Anstelle der erwähnten Verschraubung können aber auch die Gehäuseteile durch Kleben, Löten, Bördeln, Nieten, mittels Rastelementen oder anderen Verbindungstechniken fest miteinander verbunden sein. Der Gehäusedeckel 18 und der Gehäuseboden 26 sind vorzugsweise aus einem gut wärmeleitenden Material gefertigt. Wichtig ist hierbei, daß die Auflagefläche des Gehäusebodens 26, d.h. des Rands 28 auf der Leiterplatte 10, hierbei so groß ist, daß auf der darüberliegenden Seite der Leiterplatte 10 mindestens die Leistungsbauelemente 14 mit der größten Verlustwärme angeordnet werden können. Dadurch ist eine direkte Wärmeableitung vom Leistungsbauelement 14 durch die Leiterplatte 10 hindurch zum Rand 28 des Gehäusebodens 26 und somit ins Freie möglich. Um eine gute Wärmeleitfähigkeit zu erreichen, ist die Leiterplatte 10 mit Hilfe eines Haftklebers mit wärmeleitfähigen Eigenschaften verbunden. Um bei der Montage des Steuergerätes auch eine Anbindung bzw. Fixierung der Leiterplatte 10 auf dem Rand 28 des Gehäusedeckels 26 zu erreichen, weist dieser Haftkleber auch klebende Eigenschaften auf.

Ist nun die Leiterplatte 10 zwischen dem Gehäusedeckel 18 und dem Gehäuseboden 26 mit Hilfe der nicht dargestellten Verschraubungen fest eingeklemmt, so kann es aufgrund der nur am Rand anbringbaren Verschraubungen zwischen dem Rand 28 und der Unterseite 25 der Leiterplatte 10 zur Ausbildung eines keilförmigen Spalts kommen. Dieser keilförmige Spalt wird ausgehend vom äußeren Ende des Rands 28, d.h. vom Rand 23 her gesehen, zum Inneren des Gehäuses immer größer. Auch wenn es sich hierbei nur um eine minimale Spaltausbildung handelt, wird dabei über die gesamte Auflagefläche der Leiterplatte 10 auf dem Rand 28 eine unterschiedliche thermische Ableitung, d.h. ein unterschiedlicher thermischer Ableitwiderstand erzeugt. Je größer dieser Spalt ist, desto schlechter ist die Wärmeableitung von den Leistungsbauelementen 14 zu den Gehäuseteilen 18 und 26. Diese unterschiedliche thermische Ableitung kann sich negativ auf die Funktionsfähigkeit der Leistungsbauelemente 14 auswirken. Deshalb kann es notwendig sein, die Leiterplatte, d.h. mittelbar die Leistungsbauelemente 14, gleichmäßig auf den Rand 28 des Gehäusebodens 26 anzudrücken. Hierzu wird mit zusätzlichen mechanischen Hilfsmitteln eine Anpreßkraft auf die Leistungsbauelemente bzw. auf die Leiterplatte 10 erzeugt. Beim Einsatz dieser mechanischen Hilfsmittel ist aber auch auf eine Optimierung der dadurch anfallenden Kosten zu achten. In der Figur 1 wird nun mit Hilfe eines zusätzlichen Federelements 30 das Leistungsbauelement 14 auf die Leiterplatte 10 und dieses wiederum gleichmäßig auf den Rand 28 aufgedrückt. Die Anpreßkraft des Federelements 30 wirkt hierbei direkt auf das betroffene Leistungsbauelement 14 und stellt somit eine gleichmäßige Auflagefläche des Randes 28 an der Leiterplatte 10 sicher. Das Federelement 30 liegt einerseits wie erwähnt am Leistungsbauelement 14 an und andererseits an der Innenseite des Gehäusedeckels 18. Dieses Federelement 30 kann zum Beispiel an der Innenseite des Gehäusedeckels 18 angenietet sein. Um eine einfache Montage zu ermöglichen, soll das Leistungsbauelement 14 möglichst nur mit wenigen, d.h. im optimalen Fall nur mit einem Federelement 30 angedrückt werden. Um ferner eine gleichmäßige Verteilung der Anpreßkraft zu erreichen, sollte das Federelement 30 zentrisch auf dem Leistungsbauelement 14 aufliegen. Ist eine einzelne Anpressung von einem einzelnen Leistungsbauelement 14 angestrebt, so sollte das Federelement 30 etwa mittig auf dem Leistungsbauelement 14 aufliegen. Befinden sich aber am Rand der Leiterplatte 10 mehrere Leistungsbauelemente 14 hintereinander in einer Linie angeordnet, so kann mit einem länglichen unterteilten Federelement gearbeitet werden, das etwa mittig über den Leistungsbauelementen 14 zur Auflage kommt.

Die Ausbildung des Steuergeräts entsprechend der Figur 2 entspricht der nach der Figur 1. In der Figur 2 ist eine Abwandlung des mechanischen Hilfsmittels zur Anpressung des Leistungsbauelements 14 dargestellt. In der Figur 2 wird als Hilfsmittel ein elastisches Bauteil aus Kunststoff verwendet. In der Figur 2 ist dies als Elastomerstreifen 31 dargestellt. Dieser Elastomerstreifen 31 kann kreisförmigen, rechteckigen oder jeden anderen Querschnitt aufweisen, wodurch eine gleichmäßige Anpreßkraft auf das Leistungsbauelement 14 erreicht wird. Der Elastomerstreifen 31 kann hierbei an der Innenseite des Gehäusedeckels 18 angeklebt werden, so daß er nach der Montage etwa mittig auf den Leistungsbauelementen 14 aufliegt.

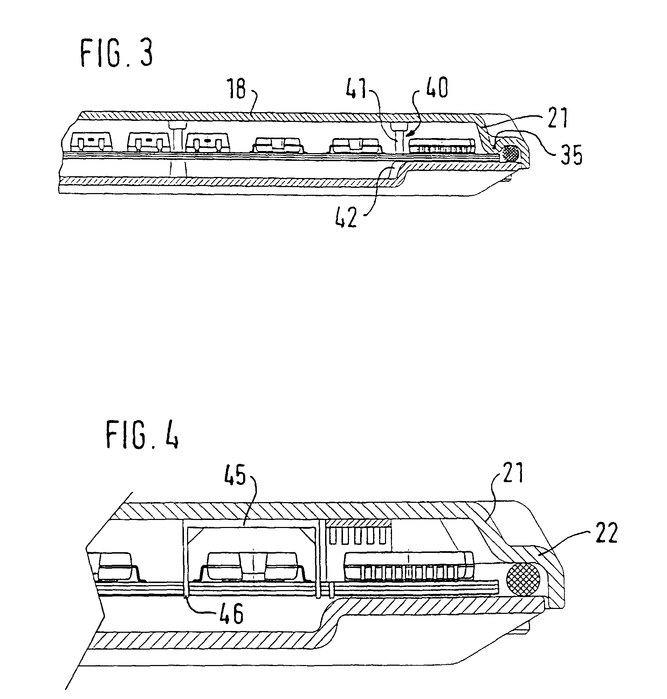

Bei dem Ausführungsbeispiel nach der Figur 3 wird die Leiterplatte 10 mit Hilfe einer im Gehäusedeckel 18 zwischen der Seitenwand 21 und dem Rand 22 ausgebildeten Sicke 35 eingeklemmt. Dadurch erhält man eine Verklemmung der Leiterplatte 10 zwischen dem Gehäusedeckel 18 und dem Gehäuseboden 26. Bei den Ausführungsbeispielen nach den Figuren 3 und 4 wird, ohne auf die Leistungsbauelemente 14 eine Anpreßkraft einwirken zu lassen, die Leiterplatte 10 direkt auf dem Rand 28 des Gehäusebodens 26 angepreßt. Hierzu ist auf der dem Rand 21 abgewandten Seite des Leistungsbauelements 14 ein zusätzliches Stützelement vorhanden. In der Figur 3 ist dieses Stützelement als mechanischer Pfosten 40 ausgebildet. Ein erster Pfostenteil 41 ist hierbei zwischen der Innenseite des Gehäusedeckels 18 und der Leiterplatte 10 und ein zweiter Pfostenteil 42 ist zwischen der Innenseite des Gehäusebodens 26 und der Unterseite der Leiterplatte 10 angeordnet. Die Höhe des zweiten Pfostenteils 42 ist hierbei auf die Höhe der Seitenwand 27 des Gehäusebodens 26 abzustimmen. Das gleiche gilt für das erste Gehäuseteil 41, das auf die Höhe der Seitenwand 21 abzustimmen ist. Um eine gleichmäßige Anpreßkraft zu erreichen, sind mehrere Stützelemente 40 gleichmäßig verteilt über die Leiterplatte angeordnet. Diese Stützelemente 40 befinden sich aber möglichst nahe am Rand 28. Diese Ausbildung ist besonders vorteilhaft bei Gußgehäuseteilen, da die ersten und zweiten Stützteile 41, 42 bereits beim Gießen am Gehäusedeckel 18 bzw. am Gehäuseboden 26 mit angegossen werden können.

Soll das Stützelemente wieder als elastisches Kunststoffteil ausgebildet sein, so weist es, wie in Figur 4 dargestellt, eine hutförmige oder bogenförmige Gestalt auf. Das Kunststoffteil 45 drückt dabei die Leiterplatte 10 auf den Rand 28 an. Ferner liegt es möglichst großflächig an der Innenwand des Gehäusedeckels 18 an. Zum Fixieren des Kunststoffteils 45 sind in der Leiterplatte 10 Bohrungen 46 vorhanden.

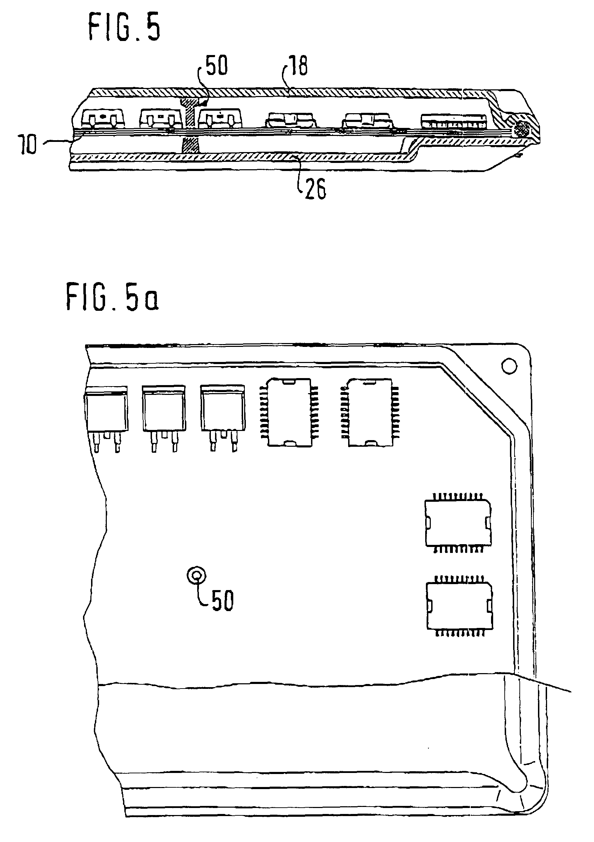

Im Ausführungsbeispiel nach der Figur 5 bzw. 5a ist da mechanische Hilfsmittel 50 zwischen der Leiterplatte 10 und dem Gehäusedeckel 18 bzw. dem Gehäuseboden 26 angeordnet. Hierbei greift das Hilfsmittel 50 nicht an den Leistungsbauelementen 14 an. Das Hilfsmittel 50 besteht aus einem Bodenteil 51, das sich zwischen der Leiterplatte 10 und dem Gehäuseboden 26 befindet, und einem Gegenlager 52, das zwischen Leiterplatte 10 und Gehäusedeckel 18 angeordnet ist. Wie aus der Figur 5a ersichtlich ist, ist das Hilfsmittel 50 etwa mittig an der Leiterplatte 10 anliegend angeordnet. Auch ist es möglich, das Hilfsmittel nur einseitig auszubilden, so daß nur ein Bodenteil oder ein Gegenlager vorhanden ist. Das Hilfsmittel kann ein zusätzlich eingesetztes Teil sein oder an der Innenseite des Gehäusebodens 26 oder des Gehäusedeckels 18 ausgebildet sein. Das Hilfsmittel kann verschraubt, verrastet oder flach aufliegend angebracht sein. Das in der Figur 5 dargestellte Hilfsmittel ist sowohl bei der Ausbildung des Steuergeräts nach Figur 1 und 2 als auch bei der Ausbildung des Steuergeräts nach Figur 3 und 4 möglich. Das Hilfsmittel kann zusätzlich zu den bei diesen Ausführungsbeispielen gezeigten Mittel angeordnet sein oder diese Mittel ersetzen.

## Patentansprüche

1. Steuergerät, bestehend aus mindestens zwei Gehäuseteilen (18, 26) und mindestens einer mit Leistungsbauelementen (14) bestückten Leiterplatte (10), wobei die Leiterplatte (10) mindestens teilweise eine Schicht aus wärmeleitendem Material aufweist, dadurch gekennzeichnet, daß die Leiterplatte (10) auf mindestens einem der Gehäuseteile (26) mit einem Bereich (28) aufliegt, der größer oder gleich der Auflagefläche mindestens eines zu kühlenden Leistungsbauelements (14) ist, daß zwischen mindestens einem zu kühlenden Leistungsbauelement (14) und dem ersten Gehäuseteil (18) ein mechanisches Hilfsmittel (30) vorhanden ist, so daß eine gleichmäßige Auflage des zweiten Gehäuseteils (26) mindestens im Bereich (28) des zu kühlenden Leistungsbauelements (14) mittel- oder unmittelbar an der Leiterplatte (10) möglich ist.

2. Steuergerät, bestehend aus mindestens zwei Gehäusteilen (18, 26) und mindestens einer mit Leistungsbauelementen (14) bestückten Leiterplatte (10), wobei die Leiterplatte (10) mindestens teilweise eine Schicht aus wärmeleitendem Material aufweist, dadurch gekennzeichnet, daß die Leiterplatte (10) auf mindestens einem der Gehäuseteile (26) mit einem Bereich (28) aufliegt, der größer oder gleich der Auflagefläche mindestens eines zu kühlenden Leistungsbauelements (14) ist, daß die Leiterplatte (10) zwischen dem ersten und dem zweiten Gehäuseteil (18, 26) eingeklemmt ist und daß ein mechanisches Hilfsmittel (40, 45) zwischen der Leiterplatte (10) und mindestens einem Gehäuseteil vorhanden ist, so daß eine gleichmäßige Auflage des Bereichs (28) des zweiten Gehäuseteils (26) mittel- oder unmittelbar an der Leiterplatte (10) möglich ist.

3. Steuergerät, bestehend aus mindestens zwei Gehäuseteilen (18, 26) und mindestens einer mit Leistungsbauelementen (14) bestückten Leiterplatte (10), wobei die Leiterplatte (10) mindestens teilweise eine Schicht aus wärmeleitendem Material aufweist, dadurch gekennzeichnet, daß die Leiterplatte (10) auf mindestens einem der Gehäuseteile (26) mit einem Bereich (28) aufliegt, der größer oder gleich der Auflagefläche mindestens eines zu bildenden Leistungsbauelements (14) ist, daß ein mechanisches Hilfsmittel (50) zwischen der Leiterplatte (10) und dem zweiten Gehäuseteil (26) oder dem ersten Gehäuseteil (18) angeordnet ist, so daß eine gleichmäßige Auflage des Bereichs (28) des zweiten Gehäuseteils (26) mittel- oder unmittelbar an der Leiterplatte (10) möglich ist.

4. Steuergerät nach Anspruch 3, dadurch gekennzeichnet, daß ein Gegenlager (52) zwischen der Leiterplatte (10) und dem zweiten Gehäuseteil (26) oder dem ersten Gehäuseteil (18) vorhanden ist.

5. Steuergerät nach Anspruch 3 oder 4, dadurch gekennzeichnet, daß das Hilfsmittel (50) mittig an der Leiterplatte (10) angeordnet ist.

6. Steuergerät nach einem der Ansprüche 1 bis 5, dadurch gekennzeichnet, daß das Hilfsmittel ein Federelement (30) ist.

7. Steuergerät nach einem der Ansprüche 1 bis 5, dadurch gekennzeichnet, daß das Hilfsmittel ein Kunststoffelement ist.

8. Steuergerät nach einem der Ansprüche 1 bis 5, dadurch gekennzeichnet, daß das Hilfsmittel ein Elastomerstreifen ist.

9. Steuergerät nach einem der Ansprüche 1 bis 5, dadurch gekennzeichnet, daß das Hilfsmittel ein Fortsatz (40) ist, der von der Innenseite des ersten Gehäuseteils (18) zur Leiterplatte (10) ragt.

10. Steuergerät nach Anspruch 9, dadurch gekennzeichnet, daß auf der dem zweiten Gehäuseteil (26) zugewandten Seite der Leiterplatte (10) ein Gegenlager (42) vorhanden ist.

11. Steuergerät nach Anspruch 10, dadurch gekennzeichnet, daß das Gegenlager ein Fortsatz (42) am zweiten Gehäuseteil (26) ist.

12. Steuergerät nach einem der Ansprüche 1 bis 11, dadurch gekennzeichnet, daß das Hilfsmittel ein topfförmig ausgebildets Kunststoffteil ist.

## Claims

1. Controller, comprising at least two housing parts (18, 26) and at least one printed circuit board (10) fitted with power components (14), the printed circuit board (10) having at least partially a layer made from thermally conducting material, characterized in that the printed circuit board (10) rests on at least one of the housing parts (26) with an area (28) which is greater than or equal to the bearing surface of at least one power component (14) to be cooled, and in that a mechanical aid (30) is present between at least one power component (14) to be cooled and the first housing part (18), so that it is possible for the second housing part (26) to bear uniformly in an indirect or direct fashion against the printed circuit board (10) at least in the area (28) of the power component (14) to be cooled.

2. Controller, comprising at least two housing parts (18, 26) and at least one printed circuit board (10) fitted with power components (14), the printed circuit board (10) having at least partially a layer made from thermally conducting material, characterized in that the printed circuit board (10) rests on at least one of the housing parts (26) with an area (28) which is greater than or equal to the bearing surface of at least one power component (14) to be cooled, and in that the printed circuit board (10) is clamped between the first and the second housing part (18, 26), and in that a mechanical aid (40, 45) is present between the printed circuit board (10) and at least one housing part, so that it is possible for the area (28) of the second housing part (26) to bear uniformly in an indirect or direct fashion against the printed circuit board (10).

3. Controller, comprising at least two housing parts (18, 26) and at least one printed circuit board (10) fitted with power components (14), the printed circuit board (10) having at least partially a layer made from thermally conducting material, characterized in that the printed circuit board (10) rests on at least one of the housing parts (26) with an area (28) which is greater than or equal to the bearing surface of at least one power component (14) to be cooled, and in that a mechanical aid (50) is arranged between the printed circuit board (10) and the second housing part (26) or the first housing part (18) so that it is possible for the area (28) of the second housing part (26) to bear uniformly in an indirect or direct fashion against the printed circuit board (10).

4. Controller according to Claim 3, characterized in that an abutment (52) is present between the printed circuit board (10) and the second housing part (26) or the first housing part (18).

5. Controller according to Claim 3 or 4, characterized in that the aid (50) is arranged in the middle on the printed circuit board (10).

6. Controller according to one of Claims 1 to 5, characterized in that the aid is a spring element (30).

7. Controller according to one of Claims 1 to 5, characterized in that the aid is a plastics element.

8. Controller according to one of Claims 1 to 5, characterized in that the aid is an elastomeric strip.

9. Controller according to one of Claims 1 to 5, characterized in that the aid is an extension (40) which projects from the inside of the first housing part (18) towards the printed circuit board (10).

10. Controller according to Claim 9, characterized in that an abutment (42) is present on the side of the printed circuit board (10) facing the second housing part (26).

11. Controller according to Claim 10, characterized in that the abutment is an extension (42) on the second housing part (26).

12. Controller according to one of Claims 1 to 11, characterized in that the aid is a plastics part of cup-shaped construction.

## Revendications

1. Appareil de commande formé d'au moins deux parties de boîtier (18, 26) et d'au moins une plaque de circuit imprimé (10) garnie de composants de puissance (14),
la plaque de circuit imprimé (10) ayant au moins en partie une couche de matière conductrice de chaleur,
caractérisé en ce que
- la plaque de circuit imprimé (10) s'appuie sur au moins une zone (28) de la partie de boîtier (26), cette zone étant supérieure ou égale à la surface d'appui d'au moins un composant de puissance (14) à refroidir,
- entre au moins un composant de puissance (14) à refroidir et la première partie de boîtier (18), il y a un accessoire mécanique (30) pour réaliser un appui régulier de la seconde partie de boîtier (26) au moins dans la zone (28) du composant de puissance (14) à refroidir, directement ou indirectement contre la plaque de circuit imprimé (10) .

2. Appareil de commande formé d'au moins deux parties de boîtier (18, 26) et d'au moins une plaque de circuit imprimé (10) garnie de composants de puissance (14), la plaque de circuit imprimé (10) ayant au moins en partie une couche de matière conductrice de chaleur,
caractérisé en ce que
- la plaque de circuit imprimé (10) s'appuie sur au moins l'une des parties de boîtier (26) par une zone (28) supérieure ou égale à la surface d'appui d'au moins un composant de puissance (14) à refroidir,
- la plaque de circuit imprimé (10) est pincée entre la première et la seconde partie de boîtier (18, 26), et
- un accessoire mécanique (40, 45) est prévu entre la plaque de circuit imprimé (10) et au moins une partie de boîtier pour permettre un appui régulier de la zone (28) de la seconde partie de boîtier (26) directement ou indirectement contre la plaque de circuit imprimé (10).

3. Appareil de commande formé d'au moins deux parties de boîtier (18, 26) et d'au moins une plaque de circuit imprimé (10) garnie de composants de puissance (14),
- la plaque de circuit imprimé (10) ayant au moins en partie une couche de matière conductrice de chaleur,
- caractérisé en ce que
- la plaque de circuit imprimé (10) s'appuie sur au moins l'une des parties de boîtier (26) suivant une zone (28) supérieure ou égale à la surface d'appui d'au moins un composant de puissance (14), et
- un accessoire mécanique (50) est prévu entre la plaque de circuit imprimé (10) et la seconde partie de boîtier (26) ou la première partie de boîtier (18) pour avoir un appui régulier de la zone (28) de la seconde partie de boîtier (26) directement ou indirectement contre la plaque de circuit imprimé (10).

4. Appareil de commande selon la revendication 3,
caractérisé par
un contre-appui (52) entre la plaque de circuit imprimé (10) et la seconde partie de boîtier (26) ou la première partie de boîtier (18).

5. Appareil de commande selon les revendications 3 ou 4,
caractérisé en ce que
l'accessoire (50) est prévu au milieu de la plaque de circuit imprimé (10).

6. Appareil de commande selon l'une quelconque des revendications 1 à 5,
caractérisé en ce que
l'accessoire est un élément à ressort (30).

7. Appareil de commande selon l'une quelconque des revendications 1 à 5,
caractérisé en ce que
l'accessoire est un élément en matière plastique.

8. Appareil de commande selon l'une quelconque des revendications 1 à 5,
caractérisé en ce que
l'accessoire est une bande en élastomère.

9. Appareil de commande selon l'une quelconque des revendications 1 à 5,
caractérisé en ce que
l'accessoire est un prolongement (40) en saillie du côté intérieur de la première partie de boîtier (18) vers la plaque de circuit imprimé (10).

10. Appareil de commande selon la revendication 9,
caractérisé en ce que
du côté de la plaque de circuit imprimé (10), opposé à la seconde partie de boîtier (26), il y a un contre-appui (42).

11. Appareil de commande selon la revendication 10,
caractérisé en ce que
le contre-appui est un prolongement (42) de la seconde partie de boîtier (26).

12. Appareil de commande selon l'une quelconque des revendications 1 à 11,
caractérisé en ce que
l'accessoire est une pièce en matière plastique en forme de pot.
